# EUROPÄISCHE PATENTSCHRIFT

(11) **EP 1 522 138 B1**
(45) Veröffentlichungstag und Bekanntmachung des Hinweises auf die Patenterteilung: **23.01.2013**
(21) Anmeldenummer: 03729839.5
(22) Anmeldetag: 16.04.2003
(51) Int. Cl.: H02M 7/00

(54) **AKTIVGLEICHRICHTER-MODUL FÜR DREHSTROMGENERATOREN VON FAHRZEUGEN**
ACTIVE RECTIFIER MODULE FOR THREE-PHASE GENERATORS OF VEHICLES
MODULE REDRESSEUR ACTIF POUR DES GENERATEURS DE COURANT TRIPHASE DE VEHICULES

(30) Priorität: 10.07.2002 DE 10231091
(43) Veröffentlichungstag der Anmeldung: 13.04.2005
(73) Patentinhaber: ROBERT BOSCH GMBH, 70442 Stuttgart (DE)
(72) Erfinder: MILICH, Reinhard, 72770 Reutlingen (DE); BALSZUNAT, Dirk, 70569 Stuttgart (DE)
(86) Internationale Anmeldenummer: PCT/DE2003/001275
(87) Internationale Veröffentlichungsnummer: WO 2004/008618

(56) Entgegenhaltungen:
- DE-A- 19 709 298
- FR-A- 2 786 657
- US-A- 6 060 795
- US-A1- 2001 012 212

## Beschreibung

### Technisches Gebiet

In Fahrzeugen kommen Drehstromgeneratoren zum Einsatz, die bei allen im Fahrbetrieb auftretenden Betriebsbedingungen genügend Strom an das Bordnetz des Fahrzeugs liefern. Damit ist sichergestellt, daß die Fahrzeugbatterie als Energiespeicher immer ausreichend geladen ist. Drehstromgeneratoren für Fahrzeuge werden für Ladespannungen von zum Beispiel 14V, 28V bei Nutzfahrzeugen und in Zukunft für das 42V-Bordnetz ausgelegt, damit 12V, 24V oder 36V-Batterien ausreichend geladen werden können. Die Aufladung von Fahrzeugbatterien und der Betrieb elektronische Baugruppen und elektrischer Geräte erfordert Gleichstrom, so daß mittels eines Gleichrichters der dreiphasige Wechselstrom des Drehstromgenerators in Gleichstrom gleichgerichtet werden kann.

### Stand der Technik

Aus DE 197 09 298 C2 gehen Startersysteme für Verbrennungskraftmaschinen hervor. Die Startersysteme weisen einen Gleichspannungs-Zwischenkreis-Wechselrichter auf. Dieser umfaßt einen Gleichspannungs-Wechselspannungsumrichter, einen Kurzzeit-Energiespeicher sowie einen bordnetzseitigen Gleichspannungswandler. Über eine Steuereinrichtung erfolgt die Steuerung der genannten Komponenten. Mittels der Steuereinrichtung wird dem Umrichter die Amplitude, die Phase und die Frequenz des an den Starter eines Fahrzeuges zu liefernden Dreiphasenstromes vorgegeben. Dem Gleichspannungswandler wird mittels der Steuereinrichtung der Strombetrag, die Stromrichtung und der Betrag der Spannungsherauf- bzw. Spannungsherabsetzung vorgegeben. Die Steuereinrichtung gibt einem Verbrauchersteuergerät ferner vor, welcher Strombetrag einem Kurzzeit-Energiespeicher entnommen werden kann und welche Spannungsdifferenz bei der Entnahme gegebenenfalls zu überwinden ist. Der Startermotor benötigt während der Startphase zusätzliche Energie aus dem Kurzzeit-Energiespeicher.

Nach erfolgtem Startvorgang arbeitet der Startermotor als Generator und liefert Energie über den Umrichter an den Zwischenkreis. Die Ausbildung des bordnetzseitigen Gleichspannungswandlers als bidirektionaler Wandler ermöglicht einerseits, elektrische Energie aus der Bordnetzbatterie in den Zwischenkreis bringen zu können und andererseits bei Generatorbetrieb des Startermotors nach dem Startervorgang Energie aus dem Zwischenkreis auf die Niederspannungsseite zu überführen. Dabei können die Verbraucher des Bordnetzes des Fahrzeuges gespeist und die Bordnetzbatterie wieder aufgeladen werden.

DE 100 62 075 A hat einen Umrichter mit integrierten Zwischenkreiskondensatoren zum Gegenstand. Der Umrichter ist mit einem einen Ladungsspeicher aufweisenden Spannungszwischenkreis verbunden. Der Umrichter gemäß dieser Lösung kann entweder eine Halbbrücken- oder eine Brückenschaltung umfassen. Diese Schaltung bildet ein innerhalb eines Gehäuses angeordnetes Modul. Der Ladungsspeicher ist in mehrere Zwischenkreiskondensatoren aufgeteilt, von denen einer, mehrere oder alle integrierter Bestandteil bzw. integrierte Bestandteile des Moduls sind.

Bei derzeit in Fahrzeugen eingesetzten Drehstromgeneratoren sind deren Gleichrichter häufig aus passiven Bauelementen aufgebaut. Dazu können hochsperrende Dioden oder Zenerdioden eingesetzt werden. Hochsperrende Dioden wirken wie ein Stromventil und stellen daher geeignete Halbleiterbauelemente zur Gleichrichtung von Wechselströmen dar. Der Strom in Sperrrichtung kann bis zu 10⁷ mal kleiner sein verglichen mit dem Durchlaßstrom. Dieser steigt mit zunehmender Temperatur stark an. Bei Zenerdioden (Z-Dioden) kommt es bei ansteigender Spannung in Rückwärtsrichtung ab Erreichen einer bestimmten Spannung zu einem steilen Anstieg des Stroms infolge Zener- oder/und Lawinendurchbruchs. Z-Dioden werden für den Dauerbetrieb innerhalb des Durchbruchsbereiches ausgelegt. Die häufigste Montageart der erwähnten Halbleiterbauelemente ist das Einpressen der Dioden in einen Kühlkörper oder in ein Kühlblech. Daneben können diese Dioden auch direkt in das Lagerschild eines Drehstromgenerators eingepreßt werden. Die Elektronik des Drehstromgenerators umfaßt neben den Halbleiterbauelementen einen Regler, mit dem der Erregerstrom sowie der Freilauf gesteuert werden.

Aus der US 6 060 795 sind Elektronik Leistungs-Packs bekannt, bei denen mehrere, z.B. drei Schichtträger stapelförmig aufeinander montiert sind. Für diese Leistungs-Packs soll ein Thermomanagement durchgeführt werden, so dass die Halbleiterkomponenten des Leistungs-Packs auch bei hohen Temperaturen eingesetzt werden können. Als Anwendungsgebiet sind beispielsweise Inverter genannt.

### Darstellung der Erfindung

Durch die erfindungsgemäß vorgeschlagene Lösung wird ein aktiver Gleichrichter bereitgestellt, der die bisherigen, passive elektronische Bauelemente umfassenden Gleichrichter ersetzt. Der erfindungsgemäß vorgeschlagene, aktive elektronische Bauelemente enthaltende Gleichrichter weist ferner eine Trennung zwischen dem Leistungsteil und dem Steuerteil auf. Die Trennung von Leistungsteil und Steuerteil am aus aktiven Bauelementen aufgebauten Gleichrichter ermöglicht eine wesentliche Verbesserung des sich einstellenden Wirkungsgrades, da als aktive elektronische Bauelemente PowerMOS-Bauelemente (Metal-Oxid-Semiconducters) eingesetzt werden, mit denen im Unterschied zu passiven elektronischen Bauelementen wie hochsperrenden Dioden wesentlich höhere Generatorleistungen gleichgerichtet werden können. Die Gleichrichtung höherer Generatorleistungen gewährleistet den Einsatz des erfindungsgemäß vorgeschlagenen aktiven Gleichrichters innerhalb des zukünftig in Fahrzeugen zu erwartenden 42V-Bordnetzes, welches entweder als das Bordnetz von Fahrzeugen zum Einsatz gelangt oder welches in Ergänzung zum bisherigen 12V-Bordnetz eingesetzt wird.

Da die Leistungsbauelemente in einem Leistungsteil (Leistungsmodul) zusammengefaßt werden, und an diesem für eine ausreichende Wärmeabfuhr zu sorgen ist, läßt sich eine Kühleinrichtung unmittelbar am Leistungsteil vorsehen oder direkt in dieses Leistungsteil (Leistungsmodul) integrieren. Mit der erfindungsgemäßen Ausbildung eines aktiven Gleichrichters sinkt ferner der Montageaufwand erheblich und es lassen sich niedrigere Herstellkosten pro Gleichrichter realisieren.

Im Hinblick auf den in Zukunft zu erwartenden Einsatz eines 42V-Bordnetzes von Fahrzeugen, für die keine kostengünstigen passiven Bauelemente wie Zenerdioden verfügbar sind, kann durch Einsatz aktiver Bauelemente wie zum Beispiel PowerMOS-Bauelemente durch die erfindungsgemäß vorgeschlagene Lösung eine kostengünstige Alternative bereitgestellt werden, die die Stückkosten pro Gleichrichter günstig beeinflußt. Der Einsatz aktivschaltender PowerMOS-Bauelemente bietet den Vorteil, daß geringere elektrische Verluste entstehen, da der Widerstand aktiv aufgeschalteter PowerMOS-Bauelemente niedriger ist als der von hochsperrenden, passiven Bauelemente darstellenden Dioden in Durchlaßrichtung. Aufgrund der verbesserten Wärmeabfuhr durch ein unmittelbar dem Leistungsteil zugeordnetes Kühlelement lassen sich höhere Generatorleistungen, die im 42V-Bordnetz auftreten, gleichrichten. Im Falle eines Lastabwurfs (Load-Dump) kann durch aktives Aufschalten der PowerMOS-Bauelemente das Verhalten des Drehstromgenerators und die Bordnetzbelastung, verglichen mit dem Verhalten bei Gleichrichtern mit passiven Bauelementen und dem Auftreten des Zenerdurchbruches an den Z-Dioden günstig beeinflußt werden. Die bauteilbedingten Parameterstreuungen der Zener-spannung führen zu einem weiten Bordnetzspannungsbereich hinsichtlich der Obergrenze bei Auftreten eines Lastabwurfes (Load-Dump). Durch ein aktives Aufschalten der PowerMOS-Bauelemente kann dieser Spannungsbereich hinsichtlich der maximal auftretenden Bordnetzspannung Uₘₐₓ verringert werden. Ferner sind bei PowerMOS-Bauelementen die bauteilbedingten Parameterstreuungen wesentlich enger toleriert.

Mit der erfindungsgemäßen Konfiguration eines aktive Bauelemente enthaltenden Gleichrichters lassen sich ferner die Leistungsverluste im Gleichrichter beim Freilauf durch aktives Aufschalten der PowerMOS-Bauelemente verringern. Mit der vorgeschlagenen Lösung können auch bisher dem Regler zugeordnete leistungsführende Bauelemente wie zum Beispiel Feldendstufen und Freilaufdioden in den Leistungsteil integriert werden. Dies ermöglicht es einerseits, den insgesamt erforderlichen Kühlaufwand zur Wärmeabfuhr am Leistungsteil (Leistungsmodul) zu konzentrieren, andererseits die thermische Verlustleistung am Reglerbaustein erheblich zu reduzieren. Ein weiterer Vorteil liegt darin, daß eine vereinfachte Montage des Regler-IC erreicht wird, wobei eine Integration von Freilaufdiode und den Feldendstufen in den Leistungsteil (Leistungsmodul) die Flexibilität hinsichtlich der Wahl des Anbauortes des Regler-ICs erheblich erweitert.

Kundenspezifische Unterschiede hinsichtlich der Steckeranschlüsse sowie des Regler-ASIC werden auf das Steuerteil (Steuermodul) begrenzt, der Leistungsteil (Leistungsmodul) des aktiven Gleichrichters wird nicht tangiert. Das Leistungsteil (Leistungsmodul) enthält den aktiven Gleichrichter, die Feldendstufe und die Freilaufdiode und stellt eine vom Kunden unabhängige Schnittstelle zum Steuerungsteil bereit. Die zur Ansteuerung des erfindungsgemäß vorgeschlagenen aktiven Gleichrichters benötigte Funh-tionalität, d.h. der Gatetreiber kann im Rahmen einer Ein-Chip-Lösung im Regler-ASIC untergebracht werden. Wird der gesamte Leistungsteil (Leistungsmodul) in beidseitiger Löttechnik ausgebildet, kann der Fertigungsaufwand niedrig gehalten werden, da Taktstraßen mit Reflowlötanlagen bzw. Vakuumdurchlauföfen zur Herstellung dieser Kontaktierungen eingesetzt werden können und eine Großserienfertigung erlauben, die mit einer Senkung der Stückkosten pro aktivem Gleichrichter gemäß der erfindungsgemäßen Lösung führen. Durch beidseitig ausgebildete Lötstellen-Kontaktierungen kann eine verbesserte thermische Anbindung ermittelt werden. Durch die Kunststoffümspritztechnik (Moulding) können die aktiven Bauelemente, d.h. PowerMOS-Bauelemente gegen äußere Einflüsse wie zum Beispiel Spritzwasser, Erschütterungen und Verschmutzungen wirkungsvoll abgeschirmt werden und bieten gleichzeitig ebene Montageflächen für zum Beispiel übereinander angeordnet montierte Leistungs- und Steuerteile des aktiven Gleichrichters.

### Zeichnung

Anhand der Zeichnung wird die Erfindung nachstehend eingehender beschrieben.

Es zeigt:
- Figur 1: die Schaltung eines Aktivgleichrichters mit Steuerteil, Leistungsteil und deren voneinander getrennte Anordnung,
- Figur 2: den Querschnitt durch einen Stapelaufbau aus Kühlkörper, oberem und unterem DBC-Trägersubstrat und zwischen diesen angeordneten aktivschaltenden Bauelementen,
- Figur 3: die Draufsicht auf das untere Substrat des Stapelaufbaus gemäß Figur 2,
- Figur 4: die Draufsicht auf das untere Substrat mit positionierten Leistungsbauelementen und Freilaufdiode,
- Figur 5: ein zwischen Substraten angeordnetes Leistungsteil mit seitlich herausgeführten Anschlüssen,
- Figur 6: ein Leistungsteil mit aufgesetzten Anschlüssen,
- Figur 7: ein mittels der Umspritztechnik umspritztes Leistungsmodul mit an der Oberseite angeordnetem Kühlkörper,
- Figuren 8.1 bis 8.3: spritzgegossene Leistungsmodule mit in unterschiedlichen Varianten seitlich herausgeführten Anschlüssen,
- Figur 9: einen Aktivgleichrichter mit auf einem Leistungsmodul aufgesetztem Steuermodul,
- Figur 10: eine Ausführungsvariante mit in den Leistungsteil standardverpacktem Steuer-IC und
- Figur 11: eine Ausführungsvariante mit in den Leistungsteil integriertem Steuerteil, dessen IC durch Drahtverbindungen mit den Leistungsteilanschlüssen verbunden ist.

### Ausführungsvarianten

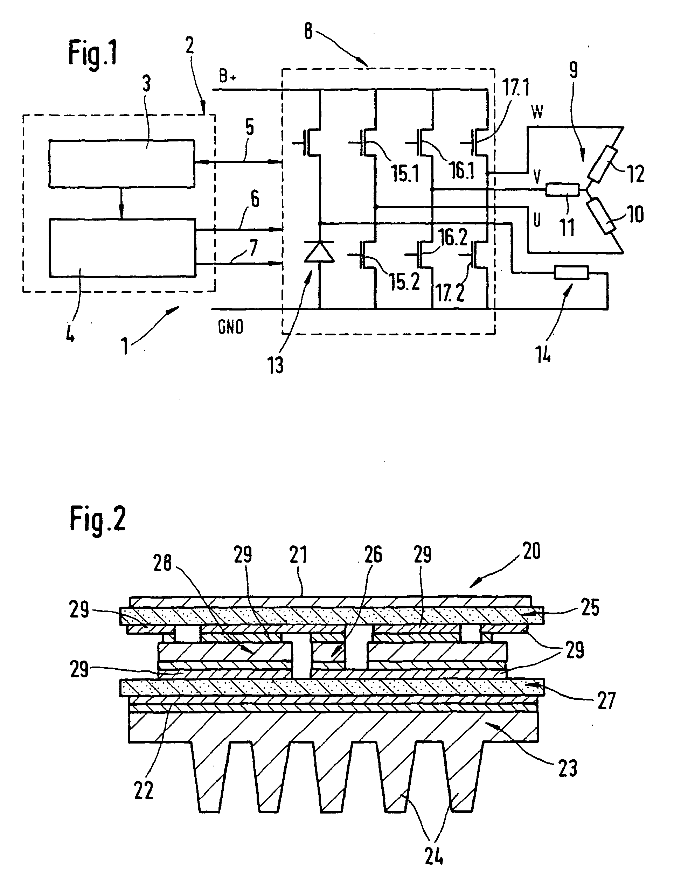

Figur 1 ist die Schaltung eines aktiven Gleichrichters mit Steuerteil, Leistungsteil und deren voneinander getrennte Anordnung zu entnehmen.

Ein gemäß des in Figur 1 dargestellten Schaltschemas aufgebauter Aktivgleichrichter 1 umfaßt ein Steuerteil 2, welches einen Regler-IC 3 sowie einen von diesem angesteuerten Gatetreiber 4 umfaßt. Anstelle der Ausführungsmöglichkeit des Steuerteils 2 (Steuermodul) in Mehr-Chip-Bauweise, wie in Figur 1 dargestellt, läßt sich der Gatetreiberbaustein 4 auch in einen Regler-IC 3 integrieren, wodurch das Steuerteil 2 des Aktivgleichrichters 1 gemäß Figur 1 auch in Ein-Chip-Bauweise ausführbar ist. Im dargestellten Ausführungsbeispiel gemäß Figur 1 stehen der Regler-IC über eine bidirektionale Ansteuerleitung 5 mit einem Leistungsteil 8 (Leistungsmodul) in Verbindung, welches leistungsführende aktivschaltende Bauelemente umfaßt. Der im Steuerteil 2 (Steuermodul) enthaltende Gatetreiber 4 steht über eine erste Ansteuerleitung 6 sowie eine zweite Ansteuerleitung 7 mit dem bevorzugt in Stapelbauweise 20 ausgebildeten Leistungsteil 8 (Leistungsmodul) in Verbindung. Das Leistungsteil 8 (Leistungsmodul) wird bevorzugt in der in Figur 2 dargestellten Stapelbauweise 20 ausgeführt. Das Leistungsteil 8 (Leistungsmodul) gemäß der Darstellung in Figur 1 umfaßt bevorzugt als PowerMOS-Bauelemente ausgeführte, Schaltfunktionen übernehmende Transistoren 15.1 bzw. 15.2, über welche eine Phase 10 (U) einer Statorwicklung 9 eines Drehstromgenerators gesteuert wird. Über das Transistorpaar 16.1 bzw. 16.2 des die leistungsführenden Bauelemente enthaltenden Leistungsteils 8 (Leistungsmodul) wird eine weitere Phase 11 (V) der Statorwicklung 9 des Drehstromgenerators gesteuert, während die als PowerMOS-Bauelemente ausgebildeten Transistoren 17.1 bzw. 17.2 die Phase 12 (W) der dreiphasigen Statorwicklung 9 eines Drehstromgenerators steuern. Im Leistungsteil 8 (Leistungsmodul) ist darüber hinaus eine Freilaufdiode 13 aufgenommen, welche einer Erregerfeldwicklung 14 zugeordnet ist, über die die dreiphasige Statorwicklung 9 des Drehstromgenerators erregt wird.

Gemäß dieser Schaltung eines Aktivgleichrichters sind alle diejenigen Bauelemente 15.1, 15.2; 16.1, 16.2; 17.1, 17.2 sowie 13 innerhalb des Leistungsteils 8 (Leistungsmodul) untergebracht. Die Steuerfunktion ist räumlich getrennt vom Leistungsteil 8 (Leistungsmodul) des Aktivgleichrichters in Ein-Chip- oder in Mehr-Chip-Bauweise innerhalb des Steuerteils 2 (Steuermodul) untergebracht.

Figur 2 zeigt den Querschnitt durch einen Stapelaufbau eines Leistungsmoduls mit Kühlkörper, oberem und unterem DBC-Trägersubstrat und zwischen diesem angeordneten aktivschaltenden PowerMOS-Bauelementen.

Aus der Darstellung gemäß Figur 2 geht eine Ausführungsvariante des Schichtaufbaus eines Leistungsteils 8 (Leistungsmodul) gemäß schematischer Darstellung in Figur 1 näher hervor. Gemäß der in Figur 2 dargestellten Ausführungsvarianten eines möglichen Stapelaufbaus 20 umfaßt dieser ein erstes Substrat 25 sowie ein weiteres, zweites Substrat 27.

Das erste Substrat 25 bzw. das zweite Substrat 27 können dabei als DBC-Träger ausgebildet sein. DBC (Direct Bonded Copper) stellt ein Substratmaterial auf Keramikbasis dar, welches beidseitig mit einer Kupferbeschichtung versehen ist. Zwischen dem ersten Substrat 25 und dem zweiten Substrat 27 des Stapelaufbaus 20 gemäß Figur 2 sind bevorzugt als PowerMOS-Bauelemente 28 ausgebildete Halbleiterbausteine aufgenommen. Die aktivschaltenden PowerMOS-Bauelemente 28 werden beidseitig über Kontaktierungsflächen 29 kontaktiert. Die Kontaktierungsflächen 29 können sowohl auf dem Wege der Flächenlöttechnik als auch durch Leitkleben hergestellt werden. Die Herstellmöglichkeit mittels eines beidseitige Kontaktierungen erlaubenden Lötverfahrens ermöglicht einen kompakten Stapelaufbau 20 des Aktivgleichrichters mit niedrigem Fertigungsaufwand bei einer gegenüber herkömmlichen Aufbauarten wesentlich verbesserten thermischen Anbindung. Im Ausführungsbeispiel des Stapelaufbaus 20 gemäß Figur 2 ist an der Unterseite 22 des Stapelaufbaus 20 ein Kühlkörper 23 als Kühleinrichtung aufgenommen, der auf seiner dem Stapelaufbau 20 abweisenden Seite mit einer Verrippung 24 zur Vergrößerung der Wärme abgebenden Oberfläche versehen ist. Es ist abhängig von der Applikation natürlich ohne weiteres möglich, den als Kühleinrichtung fungierenden Kühlkörper 23 anstatt an der Unterseite 22 des Stapelaufbaus 20 auch an dessen Oberseite 21 anzuordnen. Anstelle des in Figur 2 dargestellten, als Kühleinrichtung fungierenden Kühlkörpers 23 mit vergrößerter Wärme abgebender Oberfläche 24 kann der Stapelaufbau 20 des Leistungsteils 8 (Leistungsmodul) an der Außenseite, d.h. an der Oberseite 21 bzw. der Unterseite 22 auch durch flächiges Aufbringen einer Wärmeleitpaste nach außen kontaktiert werden. In dieser Ausführungsvariante des erfindungsgemäß vorgeschlagenen Stapelaufbaus 20 des Leistungsteils 8 (Leistungsmodul) kann der Kühlkörper 23 entfallen.

Anstelle der in Figur 2 dargestellten Variante eines Stapelaufbaus 20 des Leistungsteils 8 (Leistungsmodul) des Aktivgleichrichters 1 gemäß Figur 1 kann der Stapelaufbau 20 auch ein Stanzgitter umfassen, an welchem die einzelnen leistungsführenden Bauelemente, bevorzugt als PowerMOS-Bauelemente 28 ausgebildet, aufgenommen sind. An diese beiden zwei Schichten eines Stapelaufbaus 20 darstellenden Komponenten kann sich eine zweite Substratschicht 27 analog zum Stapelaufbau 20 gemäß Darstellung in Figur 2 anschließen, an deren Außenseite ein Kühlkörper 23 mit vergrößerter Wärme abgebender Oberfläche 24 aufgenommen sein kann. Das zweite Substrat 27 gemäß dieser alternativen Ausführungsmöglichkeit eines Stapelaufbaus 20 kann DBC sein.

In einer weiteren alternativ möglichen Ausführungsvariante des Stapelaufbaus 20 innerhalb des Leistungsteils 8 (Leistungsmodul) können das erste Substrat 25 sowie das zweite Substrat 27 durch ein IMS-Substrat ersetzt werden. Mit IMS-Substrat (Insulated Metal substrat) wird eine auf einem Al-Träger isoliert aufgebrachte Leiterbahn bezeichnet.

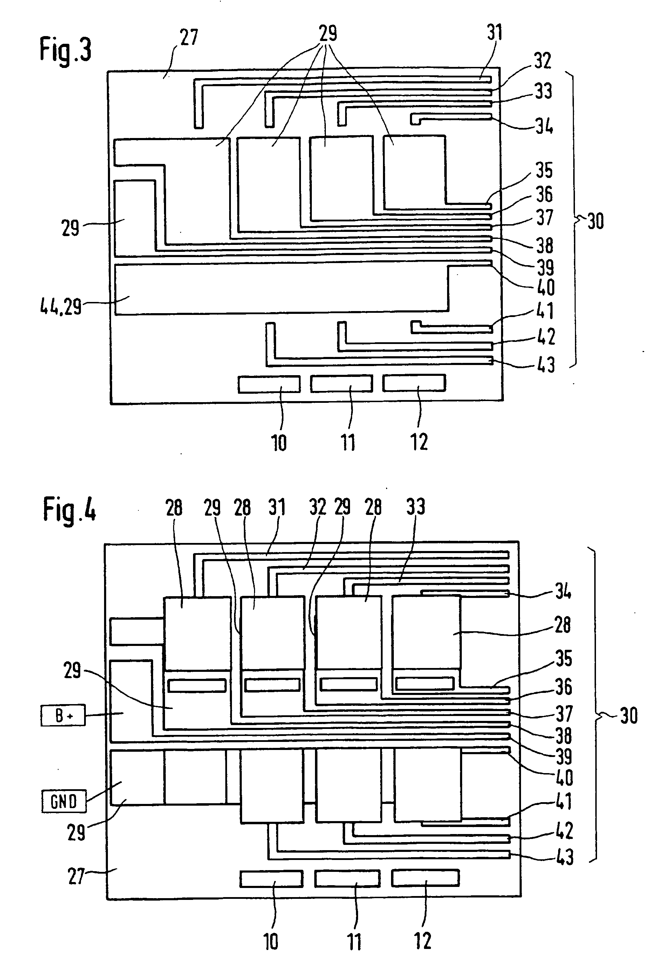

Figur 3 zeigt die Draufsicht auf ein zweites Substrat eines Stapelaufbaus gemäß der Darstellung in Figur 2.

Aus der in Figur 3 dargestellten Draufsicht auf das zweite Substrat 27 eines Stapelaufbaus 20 gemäß Figur 2 geht hervor, daß das zweite Substrat 27 an der den PowerMOS-Bauelementen 28 zuweisenden Seite mit Kontaktierungsflächen 29 versehen ist. Die Kontaktierungsflächen 29 können entweder durch Löten oder durch Leitkleben dargestellt werden. Alle Steuer- bzw. Signalanschlüsse, zusammengefaßt als Steueranschlüsse und versehen mit Bezugszeichen 30 werden bevorzugt an einer Seite des zweiten Substrates 27 herausgeführt, um die applikationsspezifische Schnittstelle zum in Figur 3 nicht dargestellten Steuerteil 2 (vgl. Darstellung in Figur 1) zu bilden. Das zweite Substrat 27 kann sowohl in DBC als auch in IMS ausgeführt sein. Die Steueranschlüsse 30 umfassen im einzelnen ein Gate 31 für die Erregerfeldwicklung 14, ein Gate 32 zum High-Side-Schalter der Phase U, ein Gate 33 zum High-Side-Schalter für die Phase V der dreiphasigen Statorwicklung 9 des Drehstromgenerators sowie ein Gate 34 zum High-Side-Schaltelement der Phase W der dreiphasigen Statorwicklung 9. Darüber hinaus sind mit den Bezugszeichen 35, 36, 37 jeweils die Potentiale der Phasen U bzw. V bzw. W der dreiphasigen Statorwicklung 9 bezeichnet. Mit Bezugszeichen 38 ist der Potentialanschluß für die Erregerfeldwicklung 14 gekennzeichnet, während am Gate 39 das Spannungsniveau anliegt

Gate 40 bezeichnet die Erdung, während die Gates 41, 42 und 43 jeweils die Ansteueranschlüsse für die Low-Side-Schalter der Phasen U, V und W der dreiphasigen Statorwicklung 9 des Drehstromgenerators bezeichnen.

Figur 4 ist die Draufsicht auf das untere Substrat eines Stapelaufbaus zu entnehmen mit positionierten Leistungsschaltelementen und Freilaufdiode.

Die Draufsicht, die in der Darstellung gemäß Figur 4 wiedergegeben ist, ähnelt der Darstellung gemäß Figur 3 mit dem Unterschied, daß über die in Figur 3 ausgebildeten Kontaktierungsflächen 29, seien sie in Löttechnik, seien sie durch Leitkleben erzeugt, die einzelnen bevorzugt als PowerMOS-Bauelemente 28 ausgebildeten leistungsführenden Bauteilen überlagert sind. Die leistungsführenden Bauelemente 28, welche die in Figur 1 dargestellten leistungsführenden Bauelemente 15.1 bzw. 15.2 für die Phase U, die leistungsführenden Bauelemente 16.1 bzw. 16.2 für die Phase V und die leistungsführenden Bauelemente 17.1 bzw. 17.2 für die Phase W der dreiphasigen Statorwicklung 9 bilden, sind durch flächige Abschnitte repräsentiert und sind des weiteren durch ein in Figur 4 nicht dargestelltes oberes Substrat 25 gemäß des Stapelaufbaus 20 überdeckt, wie Figur 2 im Querschnitt entnommen werden kann. Die Ansteueranschlüsse 30, die beispielsweise an einer offenen Seite des zweiten Substrates 27 aus dem Leistungsteil 8 (Leistungsmodul) herausgeführt werden können, entsprechen den Ansteueranschlüssen 30, die bereits im Zusammenhang mit der Figur 3 erwähnt und beschrieben wurden.

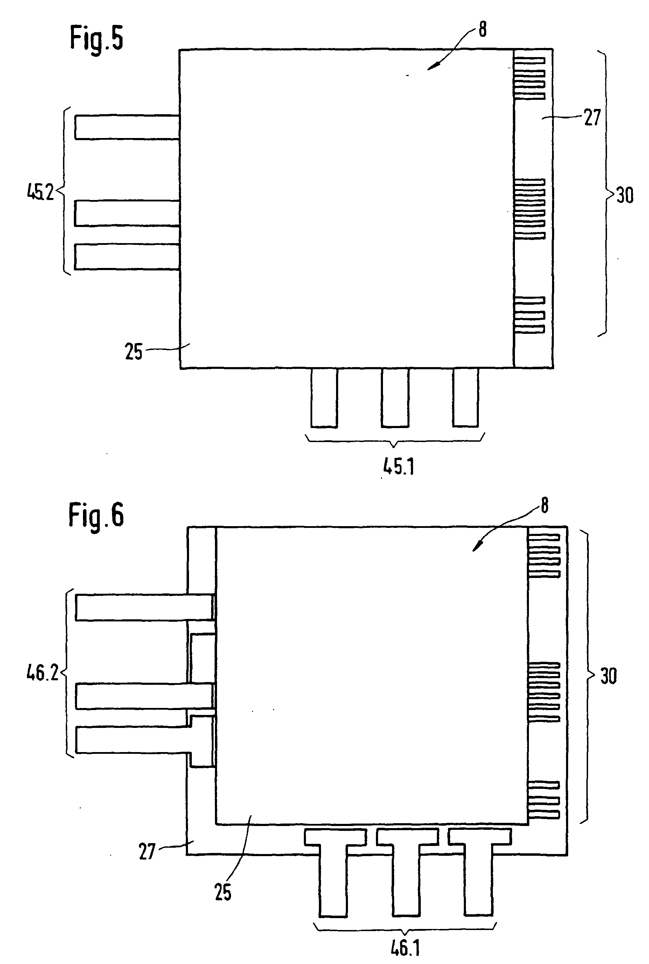

Figur 5 sind Leistungsanschlüsse zu entnehmen, welche an zwei Seiten aus dem Leistungsteil herausgeführt werden.

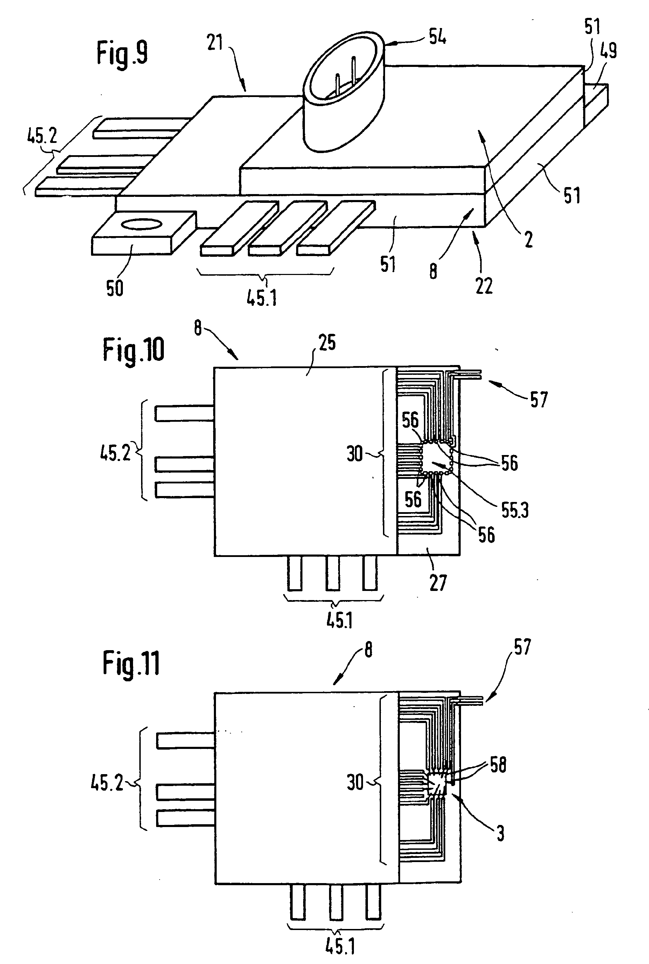

Während die in Figur 3 bzw. Figur 4 näher dargestellten einzelnen Ansteueranschlüsse 30 an einer Seite aus dem Leistungsteil 8 (Leistungsmodul) herausgeführt sind, sind Leistungsanschlüsse 45.1 bzw. 45.2 durch Kontaktierungen zwischen dem ersten Substrat 25 und dem zweiten Substrat 27 gemäß des Stapelaufbaus 20 (vgl. Darstellung gemäß Figur 2) gebildeten Kontaktierungen hervorgegangen. In der Draufsicht gemäß Figur 5 ist das erste Substrat 25 in seiner Flächenausdehnung etwas kleiner konfiguriert als das darunterliegend angeordnete zweite Substrat 27. Dadurch liegen die Ansteueranschlüsse 30 auf einer Seite des Leistungsteils 8 (Leistungsmodul) frei und können durch das in Figur 5 nicht dargestellte Leistungsteil 2 (vgl. Darstellung in Figur 9) entsprechend kontaktiert werden.

Alternativ zur in Figur 5 dargestellten Ausführungsvariante von als Kontaktierungen zwischen Substratflächen gebildeten Leistungsanschlüssen, zeigt Figur 6 eine Ausführungsvariante von Leistungsanschlüssen, die aufgesetzt sind.

Aus der Darstellung gemäß Figur 6 geht hervor, daß das Leistungsteil 8 (vgl. Stapelaufbau 20 in Figur 2) ein erstes Substrat 25 sowie ein in der Darstellung gemäß Figur 6 darunterliegendes zweites Substrat 27, sei es in DBC oder IMS ausgeführt, umfaßt. Das erste Substrat 25 ist in seiner flächigen Ausdehnung kleiner bemessen als das darunterliegend dargestellte zweite Substrat 27. Dadurch bildet sich beim Stapelaufbau 20 am zweiten Substrat 27 ein Randbereich, welcher in der Ausführungsvariante der Leistungsanschlüsse 46.1 bzw. 46.2 als Kontaktstellen für auf das zweite Substrat 27 aufzusetzende Kontaktelemente dient. Analog zur Darstellung des Leistungsteils 8 (Leistungsmodul) gemäß Figur 5 sind die Ansteueranschlüsse 30 an einer Seite des Leistungsteils 8 (Leistungsmodul) zusammengefaßt, unter dem ersten Substrat 25 herausgeführt und liegen auf einem offenen Abschnitt des zweiten Substrats 27 des Stapelaufbaus 20 (vgl. Figur 2) frei zugänglich auf.

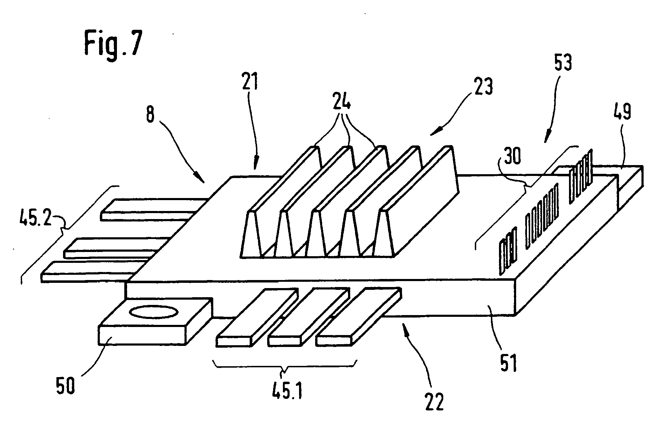

Figur 7 zeigt ein mittels eines Spritzgußmaterials umgossenes Leistungsteil mit an dessen Oberseite angeordnetem verrücktem Kühlkörper.

Aus der Darstellung gemäß Figur 7 geht hervor, daß die in Figur7 nicht dargestellte Anordnung von Substratflächen 25, 27 und zwischen diesen aufgenommenen, bevorzugt als PowerMOS-Bauelemente 28 ausgebildeten leistungsführenden Bauelemente des Aktivgleichrichters 1 von einem Kunststoffmaterial 51 blockartig umgeben sein können. Durch das Umspritzen der leistungsführenden Bauelemente 28 mit einem Kunststoffmaterial können diese wirkungsvoll gekapselt werden. In der Ausführungsvariante eines Leistungsteils 8 (Leistungsmodul) sind die Leistungsanschlüsse 45.1 bzw. 45.2, die an beiden Seiten des Leistungsteils 8 (Leistungsmodul) herausgeführt sind, als Kontaktierungen zwischen dem hier nicht dargestellten ersten Substrat 25 und dem zweiten Substrat 27 ausgebildet. Alternativ kann das Leistungsteil 8 (Leistungsmodul) - anstelle des Spritzgußmaterials 51 - auch eine Grundplatte umfassen, an der die in Figur 7 dargestellten Befestigungselemente 49, 50 - hier ausgebildet als Befestigungslaschen - angeordnet sind. Die Befestigungslaschen 49 bzw. 50 der in Figur 7 beispielsweise als Alternative dargestellten Grundplatte, können die Wirkung des an der Oberseite des Leistungsteils 8 (Leistungsmodul) angeordneten, eine vergrößerte Wärmeübertragungsfläche 24 aufweisenden Kühlkörpers 23 ergänzen oder ersetzen. Die Befestigungslaschen 49 bzw. 50 können mit Anschraublöchern oder Nietlöchem versehen sein. Diese Anschraublöcher bzw. Nietlöcher können alternativ zur Ausführung in den Befestigungslaschen 49 bzw. 50 auch unmittelbar an den Verrippungen 24 des als Kühleinrichtung dienenden, die Wärme von den leistungsführenden Bauelementen 28 abführenden Kühlkörpers 23 ausgebildet werden. In der Darstellung gemäß Figur 7 sind die Ansteueranschlüsse 30 für ein in Figur 7 nicht dargestelltes Leistungsteil (vgl. schematische Darstellung gemäß Figur 1) sich in vertikaler Richtung 53 nach oben erstreckend ausgebildet. Ein in Figur 7 nicht dargestelltes Steuerteil 2 (Steuermodul) kann zum Beispiel auf der plan verlaufenden horizontalen Oberseite des Leistungsteils 8 (Leistungsmodul) aufgesteckt werden und kontaktiert somit unmittelbar die in vertikale Richtung 53 nach oben verlaufenden Ansteueranschlüsse 30.

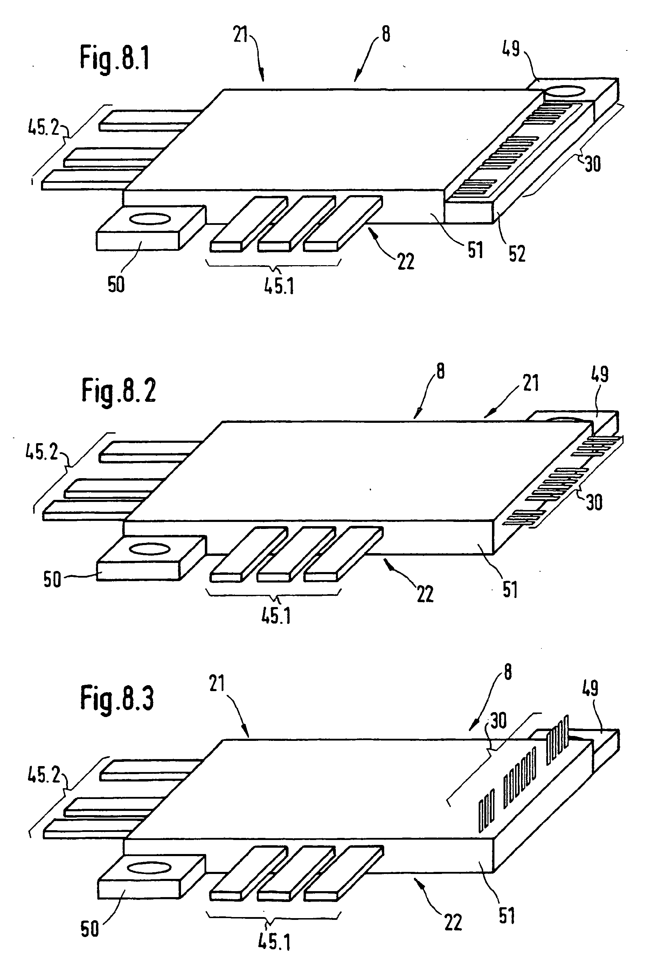

Den Figuren 8.1 bis 8.3 sind verschiedene Ausführungsvarianten der Herausführung der Ansteueranschlüsse aus einem Leistungsteil 8 (Leistungsmodul) zu entnehmen.

Den Darstellungen gemäß der Figuren 8.1, 8.2 und 8.3 ist gemeinsam, daß die in diesen Figuren nicht im einzelnen dargestellten leistungsführenden Bauelemente, bevorzugt als PowerMOS-Bauelemente ausgeführt, entweder von einem mit Bezugszeichen 51 bezeichneten Kunststoffspritzmaterial umgeben sein können oder das Leistungsteil 8 (Leistungsmodul) eine Grundplatte mit seitlich herausgeführten Befestigungselementen 49 bzw. 50 umfaßt. Die Leistungsanschlüsse für die im Inneren des in den Figuren 8.1, 8.2 und 8.3 angeordneten leistungsführenden Bauelemente 28 sind mit Bezugszeichen 45.1 bzw. 45.2 gekennzeichnet. Diese sind in den Darstellungen gemäß Figuren 8.1, 8.2 und 8.3 als Kontaktierungen zwischen dem ebenfalls nicht dargestellten ersten Substrat 25 und dem zweiten Substrat 27 ausgebildet. Alternativ können die Leistungsanschlüsse 45.1 bzw. 45.2 gemäß der Darstellung in Figur 6 als auf dem zweiten Substrat 27 aufgesetzte Kontaktierungen ausgebildet werden.

In der Darstellung gemäß Figur 8.1 erstrecken sich die Ansteueranschlüsse 30 oberhalb eines spritzungsfrei ausgebildeten Randes des zweiten Substrates 27 und sind zur Kontaktierung für ein in Figur 8.1 nicht dargestelltes Steuerteil 2 (Steuermodul) frei zugänglich.

In der Darstellung gemäß Figur 8.2 sind die Ansteueranschlüsse 30 zur Kontaktierung des in Figur 8.2 ebenfalls nicht dargestellten Steuerteils 2 (Steuermodul) seitlich aus dem Leistungsteil 8 (Leistungsmodul) herausgeführt.

Figur 8.3 zeigt in vertikaler Richtung 53 nach oben aus dem Inneren des Leistungsteils 8 (Leistungsmodul) herausgeführte Ansteueranschlüsse 30, vergleichbar der in Figur 7 dargestellten Ausführungsvariante eines Leistungsteils 8 (Leistungsmodul), welches die leistungsführenden Komponenten eines Aktivgleichrichters aufnimmt.

Wenngleich in den Figuren 8.1, 8.2 und 8.3 nicht im einzelnen dargestellt, kann sowohl an der Oberseite 21 als auch an der Unterseite 22 des Leistungsteils 8 (Leistungsmodul) eine in Figur 7 in perspektivischer Draufsicht dargestellte Kühleinrichtung 23 mit vergrößerter Wärmeabgabefläche 24 ausgebildet sein. Anstelle der in Figur 7 dargestellten Kühleinrichtung, die durch einen Kühlkörper 23 gebildet ist, lassen sich sowohl die Oberseite 21 als auch die Unterseite 22 des in den Figuren 8.1, 8.2 und 8.3 dargestellten Leistungsteils 8 (Leistungsmodul) großflächig mit einer Wärmeleitpaste versehen, über welche die Wärme, die von den leistungsführenden, bevorzugt als PowerMOS-Bauelemente 28 ausgebildeten Komponenten abgegeben wird, abgeführt werden kann. In diesen Fällen ist das Vorsehen eines verrippten Kühlkörpers 23 gemäß der Darstellung in Figur 7 bzw. gemäß des Stapelaufbaus 20, der in Figur 2 dargestellt ist, nicht erforderlich.

Figur 9 zeigt einen Aktivgleichrichter mit auf einem Leistungsmodul aufgesetzten Steuermodul.

Aus dieser Ausführungsvariante geht hervor, daß an der Oberseite 21 des Leistungsteils 8 (Leistungsmodul) ein Steuerteil 2 (Steuermodul) aufgenommen ist. Die Oberseite 21, im wesentlichen als horizontal verlaufende Fläche ausgebildet, stellt die Aufnahmefläche für das Steuerteil 2 dar. Auch das Steuerteil 2 kann in Umspritzungstechnik ausgebildet sein, so daß die im Inneren des Steuerteils 2 (Steuermodul) liegenden Reglerbausteine 3 bzw. 55 (hier nicht dargestellt) durch eine einzige Schnittstelle, nämlich den applikationsspezifischen Steckkontakt 54 kontaktiertbar sind. Der an der Oberseite gut zugänglich angebrachte applikationsspezifische Steckkontakt 54 erlaubt es in vorteilhafter Weise, kundenspezifische Unterschiede, sei es hinsichtlich des Steckkontaktes, sei es hinsichtlich des eingesetzten Regler-ICs auf ein einziges Bauteil, nämlich das Steuerteil 2 zu reduzieren. Der Leistungsteil 8 (Leistungsmodul) selbst, den aktiven Gleichrichter 1, ein oder mehrere Feldendstufen und die Freilaufdiode 13 enthaltend, stellt eine kundenunabhängige Schnittstelle bereit. Die Verbindung zwischen dem Leistungsteil 8 (Leistungsmodul) und dem Steuerteil 2 (Steuermodul) ist applikationsunspezifisch und kann beispielsweise durch die in den Figuren 8.3 bzw. 7 dargestellten, sich im wesentlichen in vertikale Richtung 53 erstreckenden Steueranschlüsse 30 durch einfaches Aufklipsen realisiert werden.

Aus der Darstellung gemäß Figur 10 geht eine Ausführungsvariante mit in den Leistungsteil aufgenommenen Steuerteil mit standardverpacktem IC hervor.

Das Leistungsteil 8 (Leistungsmodul) gemäß der Darstellung in Figur 10 umfaßt einen beispielsweise auf der zweiten Substratfläche 27 aufgenommenen standardverpackten IC 55, der beispielsweise als Regler-IC 3 (vgl. Darstellung gemäß Figur 1) dienen kann. Mit den Bezugszeichen 45.1 bzw. 45.2 sind die Leistungsanschlüsse bezeichnet, die aus dem Leistungsteil 8 (Leistungsmodul) seitlich herausgeführt sind. Die mit Bezugszeichen 30 umfassend bezeichneten Ansteueranschlüsse 30 stehen über Kontaktierungsstellen 56 des ICs 55 in Verbindung. Der IC 55 selbst kann durch Steueranschlüsse 57, die in Figur 10 schematisch angedeutet sind, angesteuert werden. Aus der Darstellung gemäß Figur 10 geht ferner hervor, daß ein oberes Substrat 25 des Leistungsteils 8 (Leistungsmodul) in einer kleineren flächigen Ausdehnung ausgebildet werden kann als das darunterliegend dargestellte zweite Substrat 27.

Das in Figur 11 dargestellte Leistungsteil 8 (Leistungsmodul) umfaßt einen Regler-IC 3, der mittels Drahtbondverbindungen 58 mit den einzelnen Ansteueranschlüssen 30 der leistungsführenden Bauelemente 28, die bevorzugt als PowerMOS-Bauelemente ausgeführt sind, verbunden werden. Auch der Regler-IC 3 gemäß der Darstellung in Figur 11 ist über Ansteueranschlüsse 57 ansteuerbar; ferner umfaßt das in Figur 11 dargestellte Leistungsteil 8 (Leistungsmodul) Leistungsanschüsse 45.1 bzw. 45.2, welche der dreiphasigen Statorwicklung 9 entsprechend eingangsseitig und ausgangsseitig aus dem Leistungsteil 8 (Leistungsmodul) des aktiven Gleichrichters 1 herausgeführt werden.

Mit der vorstehend in verschiedenen Ausführungsvarianten dargestellten Lösung läßt sich ein Aktivgleichrichter 1 darstellen, welcher bei in Zukunft einzusetzenden 42V-Bordnetzen eingebaut werden kann, für die kostengünstige Zenerdioden, die passive Bauteile darstellen, zur Gleichrichtung nicht verfügbar sind. Bei der im Aktivgleichrichter 1 vorgenommenen Gleichrichtung mittels PowerMOS-Bauelementen 28 treten wesentlich geringere elektrische Verluste auf, da der Widerstand aktiv aufgeschalteter PowerMOS-Bauelemente 28 kleiner als derjenige von Dioden in Durchlaßrichtung ist. Da höhere Ströme geschaltet werden können, können auch höhere, für das 42V-Bordnetz erforderliche Generatorleistungen gleichgerichtet werden. Auch im Falle eines Lastabwurfes kann durch den Einsatz von PowerMOS-Bauelementen 28 durch aktives Aufschalten das Verhalten des Drehstromgenerators bzw. des Bordnetzes eines Fahrzeuges günstig beeinflußt werden. Ferner lassen sich beim erfindungsgemäß vorgeschlagenen aktiven Gleichrichter 1 die Leitungsverluste im Gleichrichter beim Freilauf durch aktives Aufschalten verringern. Zusätzlich ist durch eine Bodydiode, welche prozeßbedingt im PowerMOS-Bauelement vorhanden ist, ein Freilauf auch bei Ausbleiben eines entsprechenden Ansteuersignales möglich.

Da im Leistungsteil 8 (Leistungsmodul) die leistungsführenden Bauelemente zusammengefaßt sind, kann eine effektive Kühlung am Leistungsteil 8 (Leistungsmodul) erreicht werden, sei es durch Aufbringen eines Kühlkörpers 23 mit vergrößerter Wärme abgebender Oberfläche 24, sei es durch flächiges Auftragen einer die Wärmeabfuhr begünstigenden Wärmeleitpaste an der Oberseite 21 bzw. der Unterseite 22 eines im Mould-Verfahren hergestellten Gehäuses 51 des Leistungsteils 8 (Leistungsmodul).

Die Trennung der Funktionen zwischen Steuerteil 2 (Steuermodul) und Leistungsteil 8 (Leistungsmodul) erlaubt es, die thermische Verlustleistung des Regler-ICs 3 bzw. 55, der bei bisherigen Ausführungsvarianten eine Feldendstufe und die Freilaufdiode 14 für den Erregerstrom enthielt, zu vermindern. Damit läßt sich eine wesentlich vereinfachte Montagetechnik für Regler-ICs 3 anwenden, zudem wird die Flexibilität hinsichtlich der Auswahl des Anbauortes erheblich erhöht. Mit der erfindungsgemäß vorgeschlagenen Lösung lassen sich kundenspezifische Unterschiede hinsichtlich der Steckergeometrie und der Auswahl für Reglerbausteine 3 auf ein einziges Bauteil, nämlich das Steuerteil 2 reduzieren. Der Leistungsteil 8 (Leistungsmodul) selbst, den aktiven Gleichrichter 1, die Feldendstufe sowie die Freilaufdiode 13 enthaltend, stellt eine kundenunabhängige Schnittstelle bereit. Die für die Ansteuerung des Aktivgleichrichters 1 benötigte Funktionalität in Gestalt eines Gatetreibers 4 kann beispielsweise in Ein-Chip-Bauweise in den Regler-IC 3 integriert werden und kann daneben auch als separater Chip-Baustein in Mehr-Chip-Bauweise im Steuerteil 2 (Steuermodul) untergebracht werden. Wird der Stapelaufbau 20 in den oben skizzierten Ausführungsvarianten mittels beidseitiger Löttechnik bzw. durch Leitkleben vollzogen, läßt sich ein kompakter Aufbau des Aktivgleichrichters 1 mit niedrigerem Fertigungsaufwand bei einer gegenüber üblichen Stapelbauweise wesentlich verbesserten thermischen Anbindung erzielen.

### Bezugszeichenliste

- 1: Schaltung Aktivgleichrichter
- 2: Steuerteil
- 3: Regler-IC
- 4: Gatetreiber
- 5: bidirektionale Leitung
- 6: erste Ansteuerleitung
- 7: zweite Ansteuerleitung
- 8: Leistungsteil 8 (Leistungsmodul)
- 9: Statorwicklung

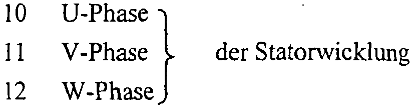

- 13: Freilaufdiode
- 14: Erregerfeldwicklung
- 15.1: 1. Transistor U-Phase
- 15.2: 2. Transistor U-Phase
- 16.1: 1. Transistor V-Phase
- 16.2: 2. Transistor V-Phase
- 17.1: 1. Transistor W-Phase
- 17.2: 2. Transistor W-Phase

- 20: Stapelaufbau
- 21: Oberseite
- 22: Unterseite
- 23: Kühleinrichtung
- 24: Wärme übertragende Fläche
- 25: erste Substratfläche
- 26: Zwischenkontaktierung
- 27: zweite Substratfläche
- 28: aktives Halbleiterbauelement (MOS) Metal-Oxid-Semiconducter
- 29: Kontaktierungsflächen
- 30: Steueranschlüsse
- 31: Gate Erregerfeldwicklung
- 32: Gate High-Side-Phase U
- 33: Gate High-Side-Phase V
- 34: Gate High-Side-Phase W
- 35: Potentialphase U
- 36: Potentialphase V
- 37: Potentialphase W
- 38: Potentialerregerfeld
- 39: B+
- 40: Erdung
- 41: Gate Low-Side-Phase U
- 42: Gate Low-Side-Phase V
- 43: Gate Low-Side-Phase W
- 44: Kontaktierungsflächen zweites Substrat
- 45.1: Leistungsanschlüsse
- 45.2: Leistungsanschlüsse
- 46.1: Leistungsanschlüsse
- 46.2: Leistungsanschlüsse
- 47: aufgesetzte erste Leistungsanschlüsse
- 48: aufgesetzte zweite Leistungsanschlüsse
- 49: erste Befestigungslasche
- 50: zweite Befestigungslasche
- 51: Spritzgußmaterial (Moulding)
- 52: offenes zweites Substrat
- 53: Vertikalanordnung Steueranschlüsse 30
- 54: applikationsspezifischer Stecker
- 55: standardverpackter IC
- 56: Kontakt für IC für Steueranschlüsse 30
- 57: Steueranschlüsse IC
- 58: Draht-Bond-Anordnung

## Patentansprüche

1. Gleichrichter zum Gleichrichten von Wechselstrom in Gleichstrom, wobei ein Drehstromgenerator eine dreiphasige Statorwicklung **(9)** umfasst und die Phasen **(11, 12, 13)** der Statorwicklung **(9)** über Schaltelemente **(15.1, 15.2; 16.1, 16.2; 17.1, 17.2)** innerhalb eines Leistungsteils **(8)** angesteuert werden, welches über ein Steuerteil **(2)** gesteuert wird, das einen Reglerbaustein **(3, 55}** umfasst, wobei der Gleichrichter **(1)** ein Steuerteil **(2)** (Steuermodul) mit Steueranschlüssen **(30}** und ein von diesem getrenntes Leistungsteil **(8)** (Leistungsmodul) umfasst, **dadurch gekennzeichnet, dass** alle leistungsführenden Bauelemente **(15.1, 15.2; 16.1, 16.2; 17.1, 17.2; 13)** als Power-MOS-Bauelemente **(28}** ausgeführt, im Stapelaufbau **(20)** integriert sind und dass der Stapelaufbau **(20}** des Leistungsteils **(8)** (Leistungsmodul) ein erstes Substrat **(25)** und ein zweites Substrat **(27)** umfasst, zwischen denen die Power-MOS-Bauelemente **(28)** über beidseitige Kontaktierungen **(29}** aufgenommen sind und ein Kühlelement **(23, 24}** vorgesehen ist, das an der Oberseite (21) des Stapelaufbaus (20) oder an der Unterseite **(22)** des Stapelaufbaus **(20)** aufgebracht ist.

2. Gleichrichter gemäß Anspruch 1, **dadurch gekennzeichnet, dass** die im Leistungsteil **(8)** (Leistungsmodul} zusammengefassten, leistungsführenden Bauelemente **(15.1, 15.2; 16.1, 16.2; 17.1, 17.2; 13)** als Power-MOS-Bauelemente **(28)** ausgeführt sind, die beidseitig kontaktiert sind.

3. Gleichrichter gemäß Anspruch 1, **dadurch gekennzeichnet, dass** das Leistungsteil **(8)** (Leistungsmodul) flächig nach außen kontaktiert ist.

4. Gleichrichter gemäß Anspruch 3, **dadurch gekennzeichnet, dass** das Leistungsteil **(8)** (Leistungsmodul) über flächig aufgetragene Wärmeleitpaste zur Wärmeabfuhr nach außen kontaktiert ist.

5. Gleichrichter gemäß Anspruch 2, **dadurch gekennzeichnet, dass** die beidseitige Kontaktierung der PowerMOS-Bauelemente **(28)** über als Lötstellen/Lötflächen ausgebildete Kontaktierungsflächen **(29)** im Stapelaufbau **(20)** erfolgt.

6. Gleichrichter gemäß Anspruch 2, **dadurch gekennzeichnet, dass** die beidseitige Kontaktierung der Power-MOS-Bauelemente **(28)** über als Leitklebflächen ausgebildete Kontaktierungsflächen **(29)** im Stapelaufbau **(20)** erfolgt.

7. Gleichrichter gemäß Anspruch 1, **dadurch gekennzeichnet, dass** der Stapelaufbau **(20)** des Leistungsteils **(8)** (Leistungsmodul) ein Stanzgitter und ein erstes Substrat **(25),** zwischen denen die Power-MOS-Bauelemente **(28)** beidseitig kontaktiert aufgenommen sind, sowie ein Kühlelement **(23, 24)** enthält.

8. Gleichrichter gemäß Anspruch 1, **dadurch gekennzeichnet, dass** der Stapelaufbau (20) des Leistungsteils **(8)** (Leistungsmodul) ein IMS-Substrat umfaßt, mit welchem die Power-MOS-Bauelemente **(28)** verbunden sind.

9. Gleichrichter gemäß Anspruch 1, **dadurch gekennzeichnet, dass** das Steuerteil **(2)** (Steuermodul) in Ein-Chip-Bauweise ausgeführt ist und einen Regler-ASIC-Baustein **(3, 55)** mit integriertem Treiberbaustein **(4)** umfasst.

10. Gleichrichter gemäß Anspruch 1, **dadurch gekennzeichnet, dass** das das Steuerteil **(2)** (Steuermodul) in Mehr-Chip-Bauweise mit separatem Regler-ASIC-Baustein **(3, 55)** und separatem Treiberbaustein **(4)** ausgebildet ist.

11. Gleichrichter gemäß Anspruch 1, **dadurch gekennzeichnet, dass** das Leistungsteil **(8)** (Leistungsmodul) Leistungsanschlüsse **(45.1, 45.2; 46.1, 46.2)** als Kontaktierungen zwischen dem ersten Substrat **(25)** und dem zweiten Substrat **(27)** des Stapelaufbaus **(20)** enthält.

12. Gleichrichter gemäß der Ansprüche 1 oder 7, **dadurch gekennzeichnet, dass** das Leistungsteil **(8)** (Leistungsmodul) Leistungsanschlüsse **(46.1, 46.2)** umfasst, die auf das erste Substrat **(25)** des Stapelaufbaus **(20)** aufgesetzt sind.

13. Gleichrichter gemäß Anspruch 1, **dadurch gekennzeichnet, dass** die Power-MOS-Bauelemente **(28)** des Stapelaufbaus **(20)** von einem Spritzgussmaterial **(51)** umgeben sind.

14. Gleichrichter gemäß der Ansprüche 3 oder 10, **dadurch gekennzeichnet, dass** die Ansteueranschlüsse **(30)** des Leistungsteils **(8)** (Leistungsmodul) auf einer offenliegenden, spritzungsfreien Fläche **(52)** einer der Substratflächen **(25, 27)** des Stapelaufbaus **(20)** herausgeführt sind.

15. Gleichrichter gemäß Anspruch 14, **dadurch gekennzeichnet, dass** die Ansteueranschlüsse **(30)** seitlich oder sich in vertikaler Richtung **(53)** erstreckend aus dem Leistungsteil **(8)** (Leistungsmodul) herausgeführt sind.

16. Gleichrichter gemäß einem oder mehrerer der vorhergehenden Ansprüche, **dadurch gekennzeichnet, dass** das Steuerteil **(2)** (Steuermodul) auf einer aus Spritzgußmaterial **(51)** gefertigten Fläche **(21)** des Leistungsteils **(8)** (Leistungsmodul) angeordnet ist und mit diesem über sich in vertikaler Richtung **(53)** herausgeführten Ansteueranschlüssen **(30)** in Verbindung steht.

17. Vorrichtung gemäß Anspruch 1, **dadurch gekennzeichnet, dass** das Steuerteil **(2)** (Steuermodul) mit einem applikationsspezifischen Element **(54)** versehen ist.

18. Gleichrichter gemäß der Ansprüche 1 oder 7, **dadurch gekennzeichnet, daß** der Stapelaufbau **(20)** eine Grundplatte mit seitlich hervorstehenden metallischen Befestigungselementen **(45, 50)** umfasst.

19. Gleichrichter gemäß der Ansprüche 1 oder 7, **dadurch gekennzeichnet, dass** das Leistungsteil **(8)** (Leistungsmodul) ein Steuerteil **(2)** (Steuermodul) enthält, welches einen standardverpackten IC **(55)** oder einen IC **(3)** mit Verdrahtung **(58)** umfasst, die jeweils Ansteueranschlüsse **(57)** aufweisen und mit den Ansteueranschlüssen **(30)** eines der Substrate **(25, 27)** des Stapelaufbaus **(20)** verbunden sind.

## Claims

1. Rectifier for rectifying alternating current into direct current, wherein a three-phase generator comprises a three-phase stator winding (9) and the phases (11, 12, 13) of the stator winding (9) are driven by switching elements (15.1, 15.2; 16.1, 16.2; 17.1, 17.2) within a power part (8) controlled by means of a control part (2) comprising a controller component (3, 55), wherein the rectifier (1) comprises a control part (2) (control module) having control connections (30) and a power part (8) (power module) separate therefrom, **characterized in that** all power-carrying components (15.1, 15.2; 16.1, 16.2; 17.1, 17.2; 13) are embodied as power MOS components (28) and are integrated in the stack construction (20), and **in that** the stack construction (20) of the power part (8) (power module) comprises a first substrate (25) and a second substrate (27), between which the power MOS components (28) are accommodated via contact-connections (29) on both sides, and a cooling element (23, 24) is provided, which is applied to the top side (21) of the stack construction (20) or to the underside (22) of the stack construction (20).

2. Rectifier according to Claim 1, **characterized in that** the power-carrying components (15.1, 15.2; 16.1, 16.2; 17.1, 17.2; 13) combined in the power part (8) (power module) are embodied as power MOS components (28) that are contact-connected on both sides.

3. Rectifier according to Claim 1, **characterized in that** the power part (8) (power module) is contact-connected externally in a planar fashion.

4. Rectifier according to Claim 3, **characterized in that** the power part (8) (power module) is contact-connected externally via thermally conductive paste applied in a planar fashion and serving for heat dissipation.

5. Rectifier according to Claim 2, **characterized in that** the power MOS components (28) are contact-connected on both sides via contact-connecting areas (29) embodied as soldering locations/soldering areas in the stack construction (20).

6. Rectifier according to Claim 2, **characterized in that** the power MOS components (28) are contact-connected on both sides via contact-connecting areas (29) embodied as conductive adhesive areas in the stack construction (20).

7. Rectifier according to Claim 1, **characterized in that** the stack construction (20) of the power part (8) (power module) contains a lead frame and a first substrate (25), between which the power MOS components (28) are accommodated in a manner contact-connected on both sides, and also a cooling element (23, 24).

8. Rectifier according to Claim 1, **characterized in that** the stack construction (20) of the power part (8) (power module) comprises an IMS substrate, to which the power MOS components (28) are connected.

9. Rectifier according to Claim 1, **characterized in that** the control part (2) (control module) is embodied in a single-chip design and comprises a controller ASIC component (3, 55) with an integrated driver component (4).

10. Rectifier according to Claim 1, **characterized in that** the control part (2) (control module) is embodied in a multi-chip design with a separate controller ASIC component (3, 55) and a separate driver component (4).

11. Rectifier according to Claim 1, **characterized in that** the power part (8) (power module) contains power connections (45.1, 45.2; 46.1, 46.2) as contact-components between the first substrate (25) and the second substrate (27) of the stack construction (20).

12. Rectifier according to Claim 1 or 7, **characterized in that** the power part (8) (power module) comprises power connections (46.1, 46.2) placed onto the first substrate (25) of the stack construction (20).

13. Rectifier according to Claim 1, **characterized in that** the power MOS components (28) of the stack construction (20) are surrounded by an injection-moulding material (51).

14. Rectifier according to Claim 3 or 10, **characterized in that** the drive connections (30) of the power part (8) (power module) are led out of an exposed, injection-free area (52) of one of the substrate areas (25, 27) of the stack construction (20).

15. Rectifier according to Claim 14, **characterized in that** the drive connections (30) are led out from the power part (8) (power module) laterally or in a manner extending in a vertical direction (53).

16. Rectifier according to one or more of the preceding claims, **characterized in that** the control part (2) (control module) is arranged on an area (21) of the power part (8) (power module) that is produced from injection-moulding material (51), and said control part is connected to said power part via drive connections (30) led out in a vertical direction (53).

17. Device according to Claim 1, **characterized in that** the control part (2) (control module) is provided with an application-specific element (54).

18. Rectifier according to Claim 1 or 7, **characterized in that** the stack construction (20) comprises a baseplate with laterally projecting metallic fixing elements (45, 50).

19. Rectifier according to Claim 1 or 7, **characterized in that** the power part (8) (power module) contains a control part (2) (control module), comprising a standard-packaged IC (55) or an IC (3) with wiring (58), which in each case have drive connections (57) and are connected to the drive connections (30) of one of the substrates (25, 27) of the stack construction (20).

## Revendications

1. Redresseur destiné à redresser un courant alternatif en courant continu et dans lequel un générateur de courants tournants comporte un bobinage de stator (9) triphasé et les phases (11, 12, 13) du bobinage de stator (9) sont commandées par l'intermédiaire d'éléments de commutation (15.1, 15.2; 16.1, 16.2; 17.1, 17.2) à l'intérieur d'une partie de puissance (8) qui est commandée par une partie de commande (2) qui comporte un module de régulateur (3, 55),
le redresseur (1) comportant une partie de commande (2) (module de commande) dotée de bornes de commande (30) et une partie de puissance (8) (module de puissance) séparée de la partie de commande, **caractérisé en ce que**
tous les composants (15.1, 15.2; 16.1, 16.2; 17.1, 17.2; 13) conduisant la puissance sont réalisés sous la forme de composants MOS de puissance (28) intégrés en une structure empilée (20),
**en ce que** la structure empilée (20) de la partie de puissance (8) (module de puissance) comporte un premier substrat (25) et un deuxième substrat (27) entre lesquels les composants MOS de puissance (28) sont repris par l'intermédiaire de contacts (29) bilatéraux et
**en ce qu'**un élément de refroidissement (23, 24) placé sur le côté supérieur (21) de la structure empilée (20) ou sur le côté inférieur (22) de la structure empilée (20) est prévu.

2. Redresseur selon la revendication 1, **caractérisé en ce que** les composants (15.1, 15.2; 16.1, 16.2; 17.1, 17.2; 13) conduisant la puissance rassemblés dans la partie de puissance (8) (module de puissance) sont réalisés sous la forme de composants MOS de puissance (28) mis en contact sur deux côtés.

3. Redresseur selon la revendication 1, **caractérisé en ce que** la partie de puissance (8) (module de puissance) est mise en contact de surface avec l'extérieur.

4. Redresseur selon la revendication 3, **caractérisé en ce qu'**en vue de l'évacuation de la chaleur, la partie de puissance (8) (module de puissance) est mise en contact de surface avec l'extérieur par l'intermédiaire d'une pâte thermoconductrice appliquée en surface.

5. Redresseur selon la revendication 2, **caractérisé en ce que** dans la structure empilée (20), la mise en contact sur les deux côtés des composants MOS de puissance (28) s'effectue par l'intermédiaire de surfaces (29) de mise en contact réalisées sous la forme d'emplacements brasés et/ou de surfaces brasées.

6. Redresseur selon la revendication 2, **caractérisé en ce que** dans la structure empilée (20), la mise en contact sur les deux côtés des composants MOS de puissance (28) s'effectue par l'intermédiaire de surfaces (29) de mise en contact réalisées sous la forme de surfaces conductrices collées.

7. Redresseur selon la revendication 1, **caractérisé en ce que** la structure empilée (20) de la partie de puissance (8) (module de puissance) contient une grille estampée et un premier substrat (25) entre lesquels les composants MOS de puissance (28) sont repris et mis en contact des deux côtés, ainsi qu'un élément de refroidissement (23, 24).

8. Redresseur selon la revendication 1, **caractérisé en ce que** la structure empilée (20) de la partie de puissance (8) (module de puissance) contient un substrat IMS par lequel les composants MOS de puissance (28) sont reliés.

9. Redresseur selon la revendication 1, **caractérisé en ce que** la partie de commande (2) (module de puissance) est réalisée en une puce et comporte un module de régulateur ASIC (3, 55) auquel est intégré un module pilote (4).

10. Redresseur selon la revendication 1, **caractérisé en ce que** la partie de commande (2) (module de puissance) est réalisée en plusieurs puces avec un module ASIC de régulateur (3, 55) et un module pilote (4) séparé.

11. Redresseur selon la revendication 1, **caractérisé en ce que** la partie de puissance (8) (module de puissance) contient des bornes de puissance (45.1, 45.2; 46.1, 46.2) qui servent de contacts entre le premier substrat (25) et le deuxième substrat (27) de la structure empilée (20).

12. Redresseur selon les revendications 1 ou 7, **caractérisé en ce que** la partie de puissance (8) (module de puissance) comporte des bornes de puissance (46.1, 46.2) appliquées sur le premier substrat (25) de la structure empilée (20).

13. Redresseur selon la revendication 1, **caractérisé en ce que** les composants MOS de puissance (28) de la structure empilée (20) sont entourés par un matériau (51) moulé par injection.

14. Redresseur selon les revendications 3 ou 10, **caractérisé en ce que** les bornes de commande (30) de la partie de puissance (8) (module de puissance) sont réalisées sur une surface libre (52) exempte de matériau d'injection de l'une des surfaces de substrat (25, 27) de la structure empilée (20).

15. Redresseur selon la revendication 14, **caractérisé en ce que** les bornes de commande (30) sont réalisées sur les côtés ou s'étendent dans la direction verticale (53) depuis la partie de puissance (8) (module de puissance).

16. Redresseur selon l'une ou plusieurs des revendications précédentes, **caractérisé en ce que** la partie de commande (2) (module de commande) est disposée sur une surface (21) en matériau (51) de moulage par injection de la partie de puissance (8) (module de puissance) et est reliée à ce module par des bornes de commande (30) qui s'étendent dans la direction verticale (53).

17. Redresseur selon la revendication 1, **caractérisé en ce que** la partie de commande (2) (module de commande) est dotée d'un élément (54) spécifique à l'application.

18. Redresseur selon les revendications 1 ou 7, **caractérisé en ce que** la structure empilée (20) comporte une plaque de base de laquelle les éléments métalliques de fixation (45, 50) débordent latéralement.

19. Redresseur selon les revendications 1 ou 7, **caractérisé en ce que** la partie de puissance (8) (module de puissance) contient une partie de commande (2) (module de commande) qui comporte un IC (55) conditionné de manière standard ou un IC (3) doté d'un câblage (58), ces IC présentant des bornes de commande (57) et étant reliés aux bornes de commande (30) de l'un des substrats (25, 27) de la structure empilée (20).
